# FASCICULE DE BREVET EUROPEEN

(11) **EP 0 647 031 B1**
(45) Date de publication et mention de la délivrance du brevet: **22.09.1999**
(21) Numéro de dépôt: 94115124.3
(22) Date de dépôt: 26.09.1994
(51) Int. Cl.: H03L 7/06, H03D 1/22

(54) **Circuit de correction du déphasage et des amplitudes**
Phasenverschiebungs- und Amplitudenkorrekturschaltung
Circuit for correcting phase-shift and amplitudes

(30) Priorité: 05.10.1993 FR 9311941
(43) Date de publication de la demande: 05.04.1995
(73) Titulaire: Eta SA Fabriques d'Ebauches, 2540 Grenchen (CH)
(72) Inventeur: Gerrits, John F. M., CH-2016 Cortaillod (CH); Pardoen, Matthijs Daniel, CH-2074 Marin (CH)
(74) Mandataire: Patry, Didier Marcel Pierre

(56) Documents cités:
- EP-A- 0 048 229
- EP-A- 0 343 273
- US-A- 5 150 128
- PATENT ABSTRACTS OF JAPAN vol. 4, no. 32 (E-2) (514) 19 Mars 1980 & JP-A-55 004 134 (MATSUSHITA DENKI SANGYO KK) 12 Janvier 1980
- PATENT ABSTRACTS OF JAPAN vol. 17, no. 542 (E-1441) 29 Septembre 1993 & JP-A-05 152 855 (FUJITSU TEN LIMITED) 18 Juin 1993

## Description

La présente invention concerne un circuit de correction du déphasage et des amplitudes pour deux signaux sinusoïdaux dont on voudrait qu'ils soient en quadrature et d'amplitudes égales. La présente invention concerne également un circuit générateur fournissant une paire de signaux sinusoïdaux en quadrature et d'amplitudes égales, et elle concerne notamment un tel générateur susceptible d'être réalisé et mis en oeuvre dans un circuit intégré fonctionnant comme circuit de démodulation de signaux à modulation par déplacement de fréquences (circuit de démodulation FSK) . Un tel circuit de correction est déjà connu du document US A-5,150,128. Ce document décrit un tel circuit qui correspond au préambule de la présente revendication 1.

Le circuit de correction de la présente invention sera décrit ci-après en relation avec un circuit de démodulation FSK. On comprendra toutefois que l'invention ne se limite absolument pas à cette application particulière.

L'utilisation d'un générateur fournissant une paire de signaux en quadrature dans un circuit de démodulation FSK est déjà connue en soi. En effet, dans les démodulateurs FSK classiques, le signal d'entrée FSK à démoduler est tout d'abord appliqué à deux circuits mélangeurs; le premier circuit mélangeur reçoit un premier signal d'analyse dont la fréquence se situe à mi-chemin entre les deux fréquences du signal d'entrée, et l'autre circuit mélangeur reçoit un deuxième signal d'analyse identique au premier mais déphasé de 90° par rapport à celui-ci.

Les signaux d'analyse reçu par les deux mélangeurs sont appelés respectivement signal I(pour In-phase) et signal Q (pour Quadrature phase).

Les signaux de sortie des mélangeurs passent ensuite dans deux filtres passe-bas afin de ne laisser passer que la fréquence différentielle entre le signal d'entrée et la fréquence de l'oscillateur local. Les signaux de sorties des deux filtres passe-bas ont donc une fréquence égale au déplacement de fréquence du signal reçu, soit (f1 - f2)/2, si f1 et f2 sont les deux fréquences du signal d'entrée. De plus, ces signaux sont également décalés en phase de 90°, et c'est soit le signal issu du deuxième mélangeur, soit le signal reçu du premier mélangeur qui présente un retard de 90° par rapport à l'autre signal, suivant que la fréquence du signal d'entrée est égale à f1 ou à f2.

L'information contenue dans le déphasage relatif des signaux de sorties des deux filtres passe-bas est extraite par un détecteur de phase qui détecte l'avance ou le retard de ces signaux l'un par rapport à l'autre et qui fournit en sortie un signal binaire représentatif du contenu binaire du signal FSK reçu.

Habituellement, le détecteur de phase numérique est conçu pour effectuer une comparaison de la phase des signaux chaque fois que la valeur de l'un de ces signaux passe par zéro. Ceci revient à un échantillonnage de fréquence 2 * (f1 - f2), un saut de phase se produisant à un instant quelconque n'étant donc détecté qu'au moment du premier instant d'échantillonnage suivant ce saut de phase. Cela signifie que le signal de sortie du détecteur de phase est entaché d'un intervalle d'incertitude (ou "jitter" selon la terminologie anglo-saxone). Dans ces conditions, si le débit binaire BR véhiculé par le signal reçu est sensiblement égal ou supérieur au déplacement de fréquence f1 - f2, il n'y aura en moyenne qu'un point d'échantillonnage ou même moins au cours de la transmission d'un bit du signal reçu, ce qui rend la démodulation correcte du message binaire transmis extrêmement difficile.

Pour obtenir une réduction considérable du "jitter" et par là, permettre, pour un taux d'erreur de détection donné, d'augmenter considérablement le débit binaire pouvant être détecté, le document US 4 322 851 suggère de produire en plus de la première paire de signaux d'analyse I et Q , au moins une paire supplémentaire de signaux d'analyse I' et Q' (et éventuellement d'autres paires I'' et Q'' etc.). Chacune des paires (I et Q, I' et Q') étant en quadrature, et les paires de signaux ayant entre elles un déphasage prédéterminé.

La figure 1 annexée est le schéma de principe d'un récepteur FSK selon le document US 4 322 851. Sur ce schéma on voit un générateur de phases 101 formé d'un oscillateur local 103 et d'un circuit déphaseur 105. Le circuit déphaseur 105 reçoit de l'oscillateur 103 un signal sinusoïdal et fournit en sortie quatre signaux d'analyse qui sont de fréquences égales à celle de l'oscillateur et qui forment deux paires en quadrature I, Q et I', Q'. Ces quatre signaux sont fournis par le générateur de phases 101 à quatre mélangeurs 107a, 107b, 107c et 107d. Chacun de ces mélangeurs reçoit également en entrée le signal FSK à démoduler. Les signaux de sortie issus des mélangeurs sont transmis à quatre filtres passebas 109a, 109b, 109c et 109d, avant d'être amplifiés puis fournis à un détecteur de phase 111. Le signal Z en sortie du détecteur de phase 111 est représentatif du contenu du signal FSK reçu.

Selon la configuration qui vient d'être décrite, le détecteur de phase 111 reçoit des mélangeurs 107 un nombre de paires de signaux égal au nombre de paires de signaux d'analyse. Le détecteur de phase numérique recevant en entrée plusieurs paires de signaux déphasées, il détecte plus souvent le passage par zéro d'un des signaux, et il éffectue donc une comparaison de la phase d'autant plus souvent que le nombre de paires de signaux est grand. Avec quatre paires de signaux par exemple, on aura une fréquence d'échantillonnage quatre fois plus grande et donc un "jitter" quatre fois plus petit qu'avec une seule paire.

Pour que le temps maximum entre deux instants d'échantillonnage successifs soit réellement réduit en proportion de l'augmentation du nombre de paires, et donc que le "jitter" soit réellement réduit, il est important de disposer d'un générateur de phases produisant des paires de signaux d'analyse exactement en quadrature et ayant entre elles des déphasages bien déterminés.

Les paires de signaux d'analyse supplémentaires I', Q', etc. peuvent être produites, comme le suggère le document FR 2 538 634 par combinaisons linéaires des deux signaux I et Q de la paire de base. La figure 2 annexée est le schéma de principe d'un générateur de phases fonctionnant en combinant linéairement les deux signaux I et Q d'une paire de base de signaux en quadrature. Le générateur de phases 101 comprend tout d'abord un oscillateur local 103 relié à l'entrée d'un déphaseur à 90° 120. L'oscillateur 103 et le déphaseur 120 forment ensemble un générateur primaire ou circuit générateur 121 fournissant une paire de signaux sinusoïdaux I et Q en quadrature. Les signaux I et Q produits sont ensuite fournis à une pluralité de paires de multiplicateurs 122a, 122b, etc. dont la fonction est de multiplier les amplitudes des signaux I et Q par les coefficients des différentes combinaisons linéaires. Les deux signaux en sortie de chacune des paires de multiplicateurs, sont ensuite additionnés par des circuits d'addition 124a, 124b pour produire les différents signaux d'analyse supplémentaires I', Q'.

A titre d'exemple, un signal I' peut être produit en faisant la somme du signal I et du signal Q, et un signal Q' peut être produit en faisant la somme du signal I et de l'inverse du signal Q (- Q). Les signaux d'une telle paire seront en quadrature et auront des déphasages de +45° et de -45° par rapport au signal I.

Dans le cas d'un générateur de phases fonctionnant par combinaisons linéaires des signaux I et Q d'une paire de base, le fait que le déphasage entre les signaux produits soit bien déterminé dépendra entièrement de ce que les deux signaux d'analyse I et Q formant la paire de base sont exactement en quadrature et d'amplitudes égales. Ce dernier point n'est pas résolu de façon satisfaisante dans les générateurs primaires connus.

Un but de la présente invention est donc de fournir un circuit de correction du déphasage et des amplitudes qui permette de corriger avec une grande précision les phases et les amplitudes de deux signaux dont on voudrait qu'il soient en quadrature et d'amplitudes égales.

Un autre but de la présente invention est de fournir un circuit générateur produisant une paire de signaux qui soit très précisément en quadrature et d'amplitudes égales.

La présente invention a donc tout d'abord pour objet un circuit de correction du déphase et des amplitudes pour deux signaux sinusoïdaux dont on voudrait qu'ils soient en quadrature et d'amplitudes égales, ledit circuit de correction comprenant un premier comparateur de phases à quadrature prévu pour recevoir en entrée les deux signaux et pour fournir en sortie un premier signal d'erreur dont la tension est représentative de l'écart entre le déphasage effectif desdits signaux et 90°, des moyens d'ajustement de la phase étant encore prévus pour, en réponse audit premier signal d'erreur, corriger la phase d'au moins un desdits signaux pour rétablir un déphasage de 90° entre les deux signaux, caractérisé en ce que ledit circuit de correction comprend encore des moyens analogiques de traitement arithmétique prévus pour fournir deux combinaisons linéaires prédéterminées desdits signaux, les coefficients respectifs desdites combinaisons linéaires prédéterminées étant choisis de telle sorte que lorsque lesdits deux signaux sont en quadrature et d'amplitudes égales, lesdites combinaisons linéaires de ceux-ci sont également en quadrature, et en ce que ledit circuit de correction comprend en outre un deuxième comparateur de phases à quadrature prévu pour recevoir en entrée lesdites deux combinaisons linéaires et pour fournir en sortie un deuxième signal d'erreur représentatif de l'écart entre le déphasage effectif desdites combinaisons linéaires et 90°, des moyens d'ajustement de l'amplitude étant encore prévus pour, en réponse audit deuxième signal d'erreur, corriger l'amplitude d'au moins un desdits signaux pour redonner auxdits signaux des amplitudes identiques.

Grâce à ces caractéristiques, le circuit de correction vérifie aussi bien la relation de quadrature existant entre les signaux de la paire de base que l'égalité de leurs amplitudes respectives. En effet, comme, d'une part, le circuit de correction selon l'invention comporte des moyens d'ajustement de la phase, maintenant un déphasage de 90° entre les signaux de la paire de base, et que, d'autre part, les coéfficients des combinaisons linéaires prédéterminées sont choisis de manière à ce que lorsque les deux signaux I et Q sont en quadrature et d'amplitudes égales leurs combinaisons linéaires sont également en quadrature, le fait de détecter que le déphasage entre les combinaisons linéaires n'est pas égal à 90°, indique que les amplitudes des signaux I et Q ne sont pas égales. Dans ces conditions, le deuxième signal d'erreur fourni aux moyens d'ajustement de l'amplitude est bien représentatif d'une différence entre les amplitudes des signaux I et Q.

Selon un mode de réalisation avantageux de la présente invention, lesdits moyens analogiques de traitement arithmétique comportent un circuit analogique d'addition et un circuit analogique de soustraction, lesdites deux combinaisons linéaires des signaux étant respectivement la somme I+Q des deux signaux et la différence I-Q des deux signaux.

La présente invention a également pour objet un circuit générateur fournissant une paire de signaux en quadrature et d'amplitudes égales comportant un circuit de correction selon la revendication 1 et deux oscillateurs destinés respectivement à fournir lesdits deux signaux sinusoïdaux, ledit générateur de phases étant caractérisé en ce qu'un premier desdits oscillateurs est un oscillateur commandé en tension connecté de façon à recevoir comme tension de commande ledit premier signal d'erreur.

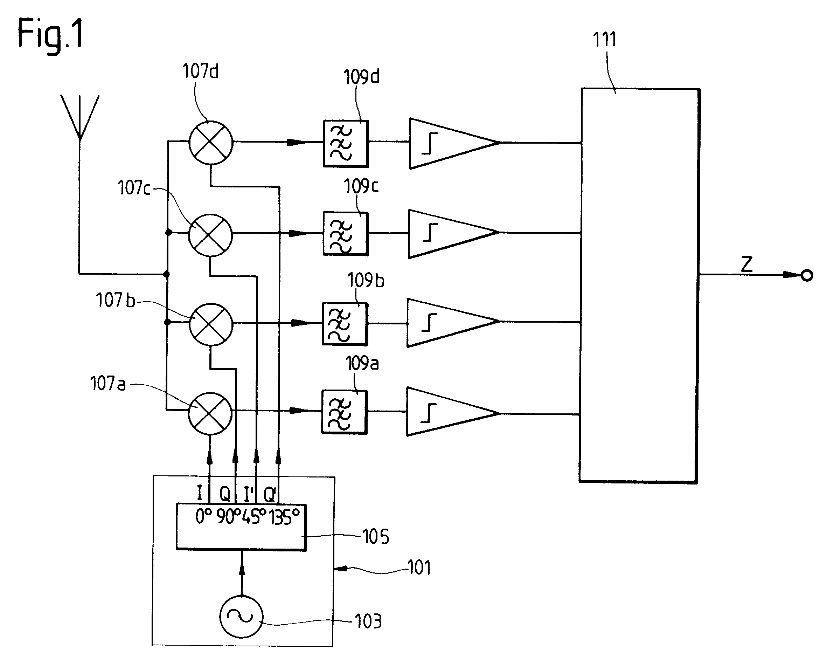

Grâce à ces caractéristiques, le circuit générateur selon l'invention pourra fournir une paire de signaux sinusoïdaux exactement en quadrature et d'amplitudes égales. Un tel circuit générateur pourra avantageusement être utilisé comme générateur primaire dans le générateur de phase d'un récepteur FSK du type de celui représenté à la figure 1, pour fournir la paire de base de signaux d'analyse. Toutefois, l'utilité du circuit générateur d'une paire de signaux en quadrature et d'amplitudes égales selon l'invention ne se limite bien évidemment pas à cette application.

D'autre caractéristiques et avantages de la présente invention apparaîtront à la lecture de la description qui va suivre, donnée uniquement à titre d'exemple et faite en se référant aux dessins annexés dans lesquels :
- la figure 1 est un schéma de principe d'un récepteur FSK de l'art antérieur;
- la figure 2 est le schéma de principe d'un générateur de phase fonctionnant en combinant linéairement les deux signaux d'une paire de base de signaux en quadrature, et qui est susceptible d'être utilisé dans le récepteur de la figure 1;
- la figure 3 est une représentation schématique d'un mode particulier de réalisation d'un circuit générateur générateur selon la présente invention destiné à fournir une paire de signaux en quadrature et d'amplitudes égales;
- la figure 4 est le schéma d'un exemple de réalisation d'un circuit électronique intégrant les deux oscillateurs commandés en tension et le circuit de commande de l'amplitude qui sont représentés à la figure 3.

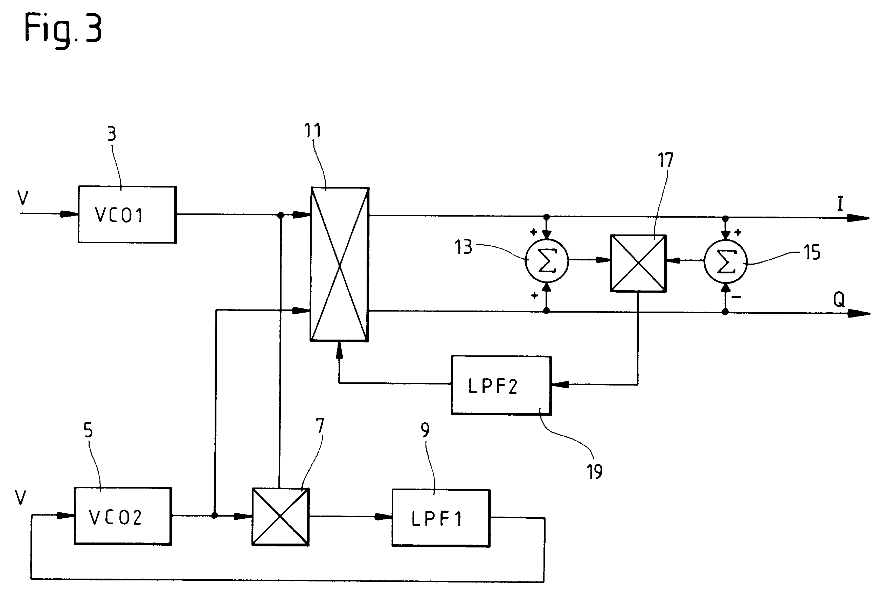

En se référant maintenant à la figure 3, on voit que le circuit générateur selon la présente invention comprend deux oscillateurs commandés en tension (VCO) référencés respectivement 3 et 5. Les entrées de commande de ces oscillateurs sont prévues pour recevoir respectivement des tensions de commmande V1 et V2. La sortie de chacun des oscillateurs 3 et 5 est reliée à l'une des entrées d'un premier multiplieur référencé 7, et la sortie de ce multiplieur 7 est reliée, via un filtre passe bas 9, à l'entrée de commande en tension d'un des deux oscillateurs (référencé 5).

La tension de commande V1 fournie à l'oscillateur 3 détermine la fréquence du signal qu'il fournit en sortie. La fréquence du signal fourni par le deuxième oscillateur 5 est toujours la même que celle de l'oscillateur 3. En effet, la boucle qui, conformément à ce qui a été décrit plus haut, relie l'oscillateur 5 au premier multiplieur 7, puis au filtre passe-bas 9, et qui enfin retourne à l'oscillateur 5 via son entrée de commande en tension, constitue une boucle à phase asservie (PLL) dont le principe est bien connu de l'homme du métier. Lors de la mise en fonction du générateur de phase, la présence de cette boucle à phase asservie, va provoquer l'asservissement de l'oscillateur 5 à la fréquence de l'oscillateur 3 mais avec un déphasage de 90° par rapport aux oscillations de ce dernier. Les signaux I et Q fournis respectivement en sortie des oscillateurs 3 et 5 seront donc en quadrature.

On voit encore sur la figure 3 que les sorties des oscillateurs 3 et 5 sont également reliées chacune à une ligne de connexion (non référencée) qui, via un circuit de commande d'amplitude référencé 11, alimente deux circuits arithmétiques analogiques référencés respectivement 13 et 15. Dans le présent exemple, les deux circuits arithmétiques 13 et 15 sont respectivement un additionneur et un soustracteur analogique, et ces deux éléments fournissent donc, en sortie, respectivement la somme et la différence des signaux I et Q qu'ils reçoivent des lignes de connexion. La sortie de chacun des circuits arithmétiques 13 et 15 est reliée à l'une des entrées d'un deuxième multiplieur référencé 17, et la sortie de ce multiplieur est reliée, via un deuxième filtre passe-bas 19 à l'entrée de commande du circuit de commande d'amplitude 11.

La boucle qui, conformément à ce qui vient d'être décrit, relie le circuit de commande d'amplitude aux circuits arithmétiques 13 et 15, puis au deuxième multiplieur 17, puis au filtre passe-bas 19 et qui, enfin, retourne au circuit de commande en amplitude 11 via son entrée de commande, constitue une boucle à amplitude asservie dont nous allons maintenant décrire le principe.

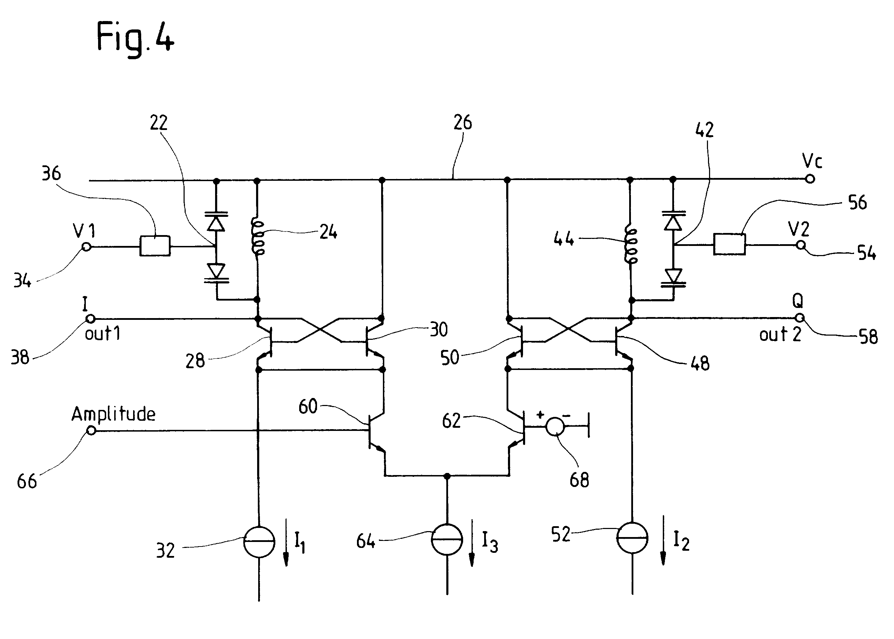

On sait des mathématiques que, pour que deux signaux égaux respectivement à la somme et à la différence de deux signaux de départ en quadrature soient eux même en quadrature, il faut et il suffit que les amplitudes des deux signaux de départ soient égales. Or, la présence de la boucle à asservissement de phase (PLL) nous garantit que les signaux I et Q produits par le deux oscillateurs (VCO) 3 et 5 sont en quadrature. Dans ces conditions, si le signal issu du deuxième multiplieur 17 et du deuxième filtre passe-bas 19 n'est pas nul, c'est que les amplitudes des signaux I et Q produites par les deux oscillateurs 3 et 5 ne sont pas égales. Dans le but d'égaliser les amplitudes, on utilise donc le signal issu du multiplieur 17 et du filtre passe-bas 19 comme tension de commande dans une boucle de rétro-action pour le circuit de commande d'amplitude 11. Un exemple de réalisation d'un circuit de commande d'amplitude sera décrit plus loin en relation avec la figure 4.

La présence simultanée de la boucle à phase asservie et de la boucle à amplitude asservie assure qu'une fois qu'ils ont traversé le circuit de commande d'amplitude, les signaux I et Q fournis par les deux oscillateurs 3 et 5 sont en quadrature et d'amplitudes égales. Le circuit que nous venons de décrire est donc bien un circuit générateur fournissant une paire de signaux en quadrature et d'amplitudes égales.

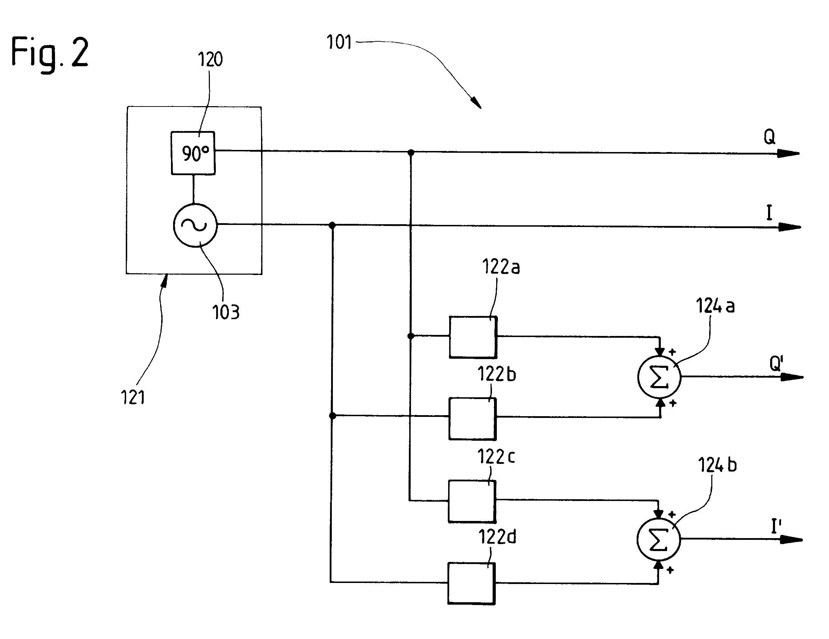

Un générateur comme celui qui vient d'être décrit peut, par exemple, remplacer avantageusement le générateur primaire 121 de la figure 2. Le circuit générateur selon l'invention présente en effet l'avantage de fournir des signaux dont les phases et les amplitudes sont plus précisément définies que celles de signaux produits de façon connue au moyen d'un oscillateur local 103 est d'un déphaseur 120 classique. De plus, le fonctionnement du circuit générateur selon l'invention est indépendant de la fréquence du signal produit, ce qui n'est généralement pas le cas avec les dispositifs classiques.

Sur la figure 4, on a représenté un circuit électronique intégrant les deux oscillateurs commandés en tension référencés 3 et 5 sur la figure 3 et le circuit de commande d'amplitude référencé 11 sur la figure 3.

Le premier oscillateur commandé en tension est formé par une diode varicap 22 montée en parallèle avec une inductance 24 entre une ligne d'alimentation positive 26 et le collecteur d'un transistor bipolaire 28. Le collecteur du transistor 28 est également relié à la base d'un deuxième transistor bipolaire 30, et ces deux transistors sont couplé par leurs émetteurs et reliés par ceux-ci à une source de courant 32. Finalement la base du transistor 28 et le collecteur du transistor 30 sont reliés à la ligne d'alimentation 26. On voit encore sur la figure 2 que l'entrée de commande de la diode varicap 22 est reliée à un noeud de liaison 34 via une résistance 36, et que le collecteur du transistor bipolaire 28 est relié à un autre noeud de liaison 38.

La boucle formée par le montage en parallèle de la diode varicap 22 et de l'inductance 24 constitue un circuit résonnant LC, et la fréquence de résonance de ce circuit dépend, de façon monotone, de la tension fournie au noeud 34 pour commander la capacité de la diode varicap. Les deux transistors 28 et 30 et la source de courant 32 forment ensemble, de façon connue, un élément amplificateur destiné à entretenir les oscillations de la boucle LC. De plus, le gain de cet élément amplificateur, et donc l'amplitude des oscillations dans la boucle, dépend directement du courant traversant les émetteurs couplés des transistors 28 et 30. Grâce au montage qui vient d'être décrit, le signal fourni par l'oscillateur au noeud 38 aura une amplitude fonction du courant traversant les émetteurs couplés des transistors 28 et 30, et une fréquence fonction de la tension fournie à la diode varicap via le noeud 34.

Une diode varicap 42, une inductance 44, des transistors bipolaires 48 et 50 et une source de courant 52 forment ensemble le deuxième oscillateur commandé en tension. Le fonctionnement de ce deuxième oscillateur est identique à celui du premier.

Le circuit de commande d'amplitude est formé par deux transistors bipolaires 60 et 62 dont les émetteurs sont reliés ensemble à une troisième source de courant 64. Le collecteur du premier transistor 60 et relié, en parallèle avec la source de courant 32, aux émetteurs des deux transistors 28 et 30 du premier oscillateur, et le collecteur du deuxième transistor 62 est relié de la même manière au émetteurs des deux transistors 48 et 50 du deuxième oscillateur. Finalement, la base du transistor 60 est reliée à un noeud de liaison 66, et la base du transistor 62 et reliée à une source de tension constante 68.

Le transistor 60 étant connecté en parallèle avec la source de courant 32, le courant déterminant pour fixer l'amplitude des oscillations dans le premier oscillateur n'est pas simplement le courant traversant la source de courant 32, mais la somme de ce courant et du courant traversant le transistor 60. De façon similaire, le courant déterminant pour fixer l'amplitude des oscillations dans le deuxième oscillateur est la somme du courant traversant la source de courant 52 et du courant traversant le transistor 62. De plus, les émetteurs des transistors 60 et 62 étant, comme nous l'avons déjà dit, reliés ensemble à la source de courant 64, la somme des courants traversant les transistors 60 et 62 est égale au courant traversant la source de courant 64, et le rapport entre le courant traversant le transistor 60 et le courant traversant le transistor 62 dépend donc de la différence entre la tension fournie à la base du transistor 60 via le noeud 66 et la tension fixe fournie à la base du transistor 62 par la source de tension 68.

Grâce à la disposition qui vient d'être décrite, il est possible de commander le rapport entre les amplitudes des signaux fournis respectivement aux noeuds 38 et 58 en agissant sur la tension fournie aux noeud 66.

Le circuit qui vient d'être décrit en relation avec la figure 4 constitue un exemple de réalisation des oscillateurs et du circuit de commande d'amplitude représenté sur la figure 3. Notons toutefois que ces éléments peuvent naturellement être réalisés d'autres manières. En particulier il est possible de prévoir que le circuit de commande d'amplitude 11 (figure 1) n'agisse que sur l'un des signaux I ou Q.

## Revendications

1. Circuit de correction du déphasage et des amplitudes pour deux signaux sinusoïdaux (I, Q) dont on voudrait qu'ils soient en quadrature et d'amplitudes égales, ledit circuit de correction comprenant un premier comparateur de phases à quadrature (7, 9) prévu pour recevoir en entrée les deux signaux et pour fournir en sortie un premier signal d'erreur dont la tension est représentative de l'écart entre le déphasage effectif desdits signaux et 90°, des moyens d'ajustement de la phase (42) pour, en réponse audit premier signal d'erreur, corriger la phase d'au moins un desdits signaux pour rétablir un déphasage de 90° entre les deux signaux, des moyens d'ajustement de l'amplitude (66, 60) étant encore prévus pour corriger l'amplitude d'un desdits signaux, caractérisé en ce que ledit circuit de correction comprend encore des moyens analogiques de traitement arithmétique (13, 15) prévus pour fournir deux combinaisons linéaires prédéterminées desdits signaux, les coefficients respectifs desdites combinaisons linéaires prédéterminées étant choisis de telle sorte que, lorsque lesdits deux signaux (I, Q) sont en quadrature et d'amplitudes égales, lesdites combinaisons linéaires de ceux-ci sont également en quadrature, et en ce que ledit circuit de correction comprend en outre un deuxième comparateur de phases à quadrature (17, 19) prévu pour recevoir en entrée lesdites deux combinaisons linéaires et pour fournir en sortie un deuxième signal d'erreur représentatif de l'écart entre le déphasage effectif desdites combinaisons linéaires et 90°, lesdits moyens d'ajustement de l'amplitude pouvant, en réponse audit deuxième signal d'erreur, corriger l'amplitude d'au moins un desdits signaux pour redonner auxdits signaux des amplitudes identiques.

2. Circuit de correction selon la revendication 1, caractérisé en ce que lesdits moyens analogiques de traitement arithmétique (13, 15) comportent un circuit analogique d'addition (13) et un circuit analogique de soustraction (15), lesdites deux combinaisons linéaires des signaux (I, Q) étant respectivement la somme des deux signaux et la différence des deux signaux.

3. Circuit de correction selon la revendication 1, caractérisé en ce que lesdits premier et deuxième comparateurs de phases à quadrature sont formés, chacun, d'un multiplieur (7, 17) et d'un filtre passe-bas (9, 19) connecté à la sortie dudit multiplieur.

4. Circuit générateur comportant un circuit de correction selon la revendication 1 et deux oscillateurs (3, 5) destinés respectivement à fournir lesdits deux signaux sinusoïdaux (I, Q), ledit circuit générateur étant caractérisé en ce qu'au moins un premier (5) desdits oscillateurs est un oscillateur commandé en tension, connecté de façon à recevoir comme tension de commande ledit premier signal d'erreur.

## Patentansprüche

1. Phasenverschiebungs- und Amplitudenkorrekturschaltung für zwei Sinussignale (I, Q), von denen gewollt ist, daß sie um 90° phasenverschoben sind und gleiche Amplituden aufweisen, wobei die Korrekturschaltung einen ersten 90°-Phasenverschiebungskomparator (7, 9), der dazu vorgesehen ist, die beiden Signale eingangsseitig zu empfangen und ausgangsseitig ein erstes Fehlersignal zu erzeugen, dessen Spannung dem Unterschied zwischen der effektiven Phasenverschiebung der Signale und 90° entspricht, Mittel zum Einstellen der Phase (42), um die Phase mindestens eines der Signale in Reaktion auf das erste Fehlersignal zu korrigieren, um eine Phasenverschiebung von 90° zwischen den zwei Signalen wiederherzustellen, Mittel (66,60) zum Einstellen der Amplitude, die zudem vorgesehen sind, um die Amplitude eines der Signale zu korrigieren, umfaßt, dadurch gekennzeichnet, daß die Korrekturschaltung zudem analoge Mittel (13, 15) zur arithmetischen Verarbeitung umfaßt, die zum Erzeugen zweier vordefinierter linearer Kombinationen der Signale vorgesehen sind, wobei die entsprechenden Koeffizienten der vordefinierten linearen Kombinationen derart gewählt werden, daß die zwei Signale (I, Q) um 90° phasenverschoben sind und gleiche Amplituden aufweisen, wobei die linearen Kombinationen von diesen gleichfalls um 90° phasenverschoben sind, und dadurch, daß die Korrekturschaltung zudem einen zweiten 90°-Phasenverschiebungskomparator (17, 19) umfaßt, der zum eingangsseitigen Empfangen der beiden linearen Kombinationen und zum ausgangsseitigen Erzeugen eines zweiten Fehlersignals vorgesehen ist, welches dem Unterschied zwischen der effektiven Phasenverschiebung der linearen Kombinationen und 90° entspricht, wobei die Mittel zum Einstellen der Amplitude in Reaktion auf das zweite Fehlersignal die Amplitude mindestens eines der Signale korrigieren können, um den Signalen identische Amplituden zurückzugeben.

2. Korrekturschaltung nach Anspruch 1, dadurch gekennzeichnet, daß die analogen Mittel (13, 15) zur arithmetischen Verarbeitung einen analogen Additionsschaltkreis (13) und einen analogen Substraktionsschaltkreis (15) umfassen, wobei die zwei linearen Kombinationen der Signale (I, Q) die Summe der zwei Signale bzw. die Differenz der zwei Signale sind.

3. Korrekturschaltung nach Anspruch 1, dadurch gekennzeichnet, daß die ersten und zweiten 90°-Phasenverschiebungskomparatoren jeweils aus einem Multiplizierer (7, 17) und einem Tiefpaßfilter (9, 19), das mit dem Ausgang des Multiplizierers verbunden ist, gebildet werden.

4. Erzeugungsschaltung mit einer Korrekturschaltung nach Anspruch 1 und zwei Oszillatoren (3, 5), die dazu bestimmt sind, die zwei Sinussignale (I, Q) zu erzeugen, wobei der Erzeugungsschaltung dadurch gekennzeichnet ist, daß mindestens ein erster (5) der Oszilllatoren ein spannungsgesteuerter Oszillator ist, der so geschaltet ist, daß er als Steuerspannung das erste Fehlersignal empfängt.

## Claims

1. Phase shift and amplitude correction circuit for two sinusoidal signals (I, Q) which are desired to be in quadrature and to have equal amplitudes, said correction circuit comprising a first quadrature phase comparator (7, 9) provided for receiving as input the two signals and providing as output a first error signal the voltage of which is representative of the difference between the effective phase shift of said signals and 90°, phase adjustment means (42) provided for, in response to said first error signal, correcting the phase of at least one of said signals to retrieve a phase shift of 90° between the two signals, amplitude adjustment means (66, 60) also being provided for correcting the amplitude of one of said signals, characterized in that said correction circuit further comprises analogue arithmetic processing means (13, 15) provided for providing two predetermined linear combinations of said signals, the respective coefficients of said predetermined linear combinations being chosen so that, when said two signals (I, Q) are in quadrature and have equal amplitudes, said linear combinations are also in quadrature, and in that said correction circuit further comprises a second quadrature phase comparator (17, 19) provided for receiving as input said two linear combinations and providing as output a second error signal representative of the difference between the effective phase shift of said linear combinations and 90°, said amplitude adjustment means (66, 60) being capable of, in response to said second error signal, correcting the amplitude of at least one of said signals to retrieve identical amplitudes to said signals.

2. Correction circuit according to claim 1, characterized in that said analogue arithmetic processing means (13, 15) include an analogue addition circuit (13) and an analogue subtraction circuit (15), said two linear combinations of the signals (I, Q) being the sum of the two signals and the difference of the two signals, respectively.

3. Correction circuit according to claim 1, characterized in that said first and second quadrature phase comparators are each formed of a multiplier (7, 17) and a low-pass filter (9, 19) connected to the output of said multiplier.

4. Generator circuit comprising a correction circuit according to claim 1 and two oscillators (3, 5) intended for providing said two sinusoidal signals (I, Q), respectively, said generator circuit being characterized in that at least a first (5) of said oscillators is a voltage controlled oscillator, connected so as to receive as control voltage said first error signal.
